# EUROPEAN PATENT APPLICATION

(11) **EP 4 645 364 A1**
(43) Date of publication of application: **05.11.2025**
(21) Application number: 23909056.6
(22) Date of filing: 28.06.2023
(51) Int. Cl.: H01J 37/32

(54) **FOCUSING RING REPLACEMENT DEVICE AND PLASMA ETCHING MACHINE**

(30) Priority: 31.12.2022 CN 202211739258
(71) Applicant: Jiangsu Leuven Instruments Co., Ltd., Xuzhou, Jiangsu 221300 (CN)
(72) Inventor: CHEN, Shuai, Xuzhou, Jiangsu 221300 (CN); LIU, Haiyang, Xuzhou, Jiangsu 221300 (CN); LIU, Xiaobo, Xuzhou, Jiangsu 221300 (CN); LI, Hao, Xuzhou, Jiangsu 221300 (CN); HE, Xiaoming, Xuzhou, Jiangsu 221300 (CN); HU, Dongdong, Xuzhou, Jiangsu 221300 (CN); XU, Kaidong, Xuzhou, Jiangsu 221300 (CN)
(74) Representative: Eisenführ Speiser
(86) International application number: PCT/CN2023/103055
(87) International publication number: WO 2024/139111

(57) **Abstract**

A focusing ring replacement device, comprising a driving device (30), an ejector pin lifting mechanism (10), and a focusing ring lifting mechanism (20). The ejector pin lifting mechanism (10) comprises a first ejector pin (11) and a first linkage member (12), and the first ejector pin (11) is arranged at the top of the first linkage member (12) and can extend out through a through hole in an edge ring (50); and the focusing ring lifting mechanism (20) comprises a second ejector pin (21) and a second linkage member (22), and the second ejector pin (21) is arranged at the top of the second linkage member (22) and can extend out through a through hole of a base (40). The driving device (30) is fixedly arranged below a lower electrode (70), and an output end thereof is respectively connected to the first linkage member (12) and the second linkage member (22), so as to respectively drive the first ejector pin (11) of the ejector pin lifting mechanism (10) and the second ejector pin (21) of the focusing ring lifting mechanism (20) to ascend and descend, thereby simplifying the configuration of the structure and reasonably reducing the device costs.

## Description

The present application claims the priority to Chinese Patent Application No. 202211739258.4, titled "FOCUSING RING REPLACEMENT DEVICE AND PLASMA ETCHING MACHINE", filed with the China National Intellectual Property Administration on December 31, 2022, the entire content of which is incorporated herein by reference.

### FIELD

The present application relates to the technical field of semiconductor processing equipment, and in particular to a focus ring replacement device and a plasma etcher.

### BACKGROUND

As is well known, a lower electrode structure is provided in a vacuum reaction chamber of a plasma etching apparatus, and a focus ring is arranged around a base of the lower electrode for supporting a substrate, so as to improve the uniformity of plasma distribution close to an edge part of the substrate to be processed. Generally, during the plasma etching of the substrate, the focus ring is also etched, resulting in a non-uniform plasma distribution at the edge of the substrate being processed. Therefore, when the focus ring has been etched to a certain extent, it needs to be replaced in time.

According to a typical existing approach, a focus ring lifting structure is provided in the vacuum reaction chamber to automatically lift and lower the focus ring. After the focus ring is lifted to a certain position, it can be removed from a transfer port for loading and unloading the substrate, thereby achieving the replacement of the focus ring. Specifically, in an etcher or other apparatuses, the focus ring lifting mechanism is located inside the vacuum reaction chamber and includes a driving rod and a driving source for lifting and lowering the driving rod. A shielding ring is arranged below the base, and the driving source is arranged inside the shielding ring. The driving rod extends through the base to be located under the focus ring to lift and lower the focus ring. That is to say, the focus ring is moved upward and downward through the driving rod and the driving source for lifting and lowering the driving rod. The focus ring lifting structure employs a standalone driving device for lifting and lowering, which is independent of other lifting devices of the apparatus in practice, making the structure complicated.

In view of this, the existing focus ring replacement device needs to be optimized in design to overcome the above defect of complex structure.

### SUMMARY

In order to solve the above technical problem, a focus ring replacement device and a plasma etcher are provided according to the present application, which simplify the structure and reasonably reduce the device cost through an optimized design.

A focus ring replacement device according to the present application is for a plasma etcher. The focus ring replacement device includes a driving device, an pin lifting mechanism, and a focus ring lifting mechanism. The pin lifting mechanism includes a first pin and a first linkage member, and the first pin is arranged at a top of the first linkage member and is configured to extend out of a through-hole of an edge ring. The focus ring lifting mechanism includes a second pin and a second linkage member, and the second pin is arranged at a top of the second linkage member and is configured to extend out of a through-hole of a base. The driving device is fixed below a lower electrode. An output end of the driving device is connected to the first linkage member and the second linkage member, and is configured to lift and lower the first pin of the pin lifting mechanism and the second pin of the focus ring lifting mechanism.

In an embodiment, the number of the first pin and the number of the second pin are both plural, the plurality of first pins are uniformly distributed in a circumferential direction, and the plurality of second pins are uniformly distributed in the circumferential direction.

In an embodiment, each of the first pin and the second pin includes a spherical protruding end.

In an embodiment, each of the first pin and the second pin is made of ceramic or stainless steel.

In an embodiment, the driving device is a double-acting cylinder. The double-acting cylinder includes an outer output member and an inner output member that is inserted in the outer output member, and a lower end of the inner output member extends out of the outer output member. The outer output member is connected to the first linkage member, and the inner output member is connected to the second linkage member.

In an embodiment, the outer output member has a first driving stroke, the inner output member has a second driving stroke which is greater than the first driving stroke, and a difference between the second driving stroke and the first driving stroke is greater than or equal to a thickness of a focus ring.

In an embodiment, the driving device is a linear driving motor, an output shaft of the linear driving motor is connected to the first linkage member via a decouplable linkage mechanism, and the output shaft is fixedly connected to the second linkage member. A junction between the second linkage member and the output shaft is located below a junction between the first linkage member and the output shaft.

In an embodiment, the linkage mechanism is configured to be decoupled when an axial force between the first linkage member and the output shaft is greater than a coupling threshold.

In an embodiment, a limiting ring is provided on the driving device and is arranged around the output shaft. A spacing is present between the first linkage member and the limiting ring in an axial direction, and the limiting ring is configured to limit position of the first linkage member in the axial direction to facilitate the decoupling of the linkage mechanism.

In an embodiment, the focus ring replacement device further includes an elastic member, which is provided between the first linkage member and the second linkage member. The elastic member is configured to be deformed when the second linkage member drives the second pin to raise the focus ring.

In an embodiment, the focus ring replacement device further includes a guide post, and the elastic member is arranged around the guide post.

In an embodiment, the elastic member is a spring, a bellows, or a rubber member.

In an embodiment, the driving device is a double-ended cylinder, which includes a first cylinder rod and a second cylinder rod that extend in opposite directions. The first cylinder rod is connected to the first linkage member of the pin lifting mechanism, and the second cylinder rod is connected to the second linkage member of the focus ring lifting mechanism.

In an embodiment, the second pin of the focus ring lifting mechanism is partially located in a mounting groove of a lower electrode support seat.

In an embodiment, a seal is provided between the first pin and the base, and a seal is provided between the second pin and the edge ring.

In an embodiment, the driving device is fixed below the first linkage member and the second linkage member.

In an embodiment, the driving device is a linear driving motor. A first output shaft of the linear driving motor is connected to the first linkage member, and a second output shaft of the linear driving motor is connected to the second linkage member. A junction between the second linkage member and the second output shaft is located below a junction between the first linkage member and the first output shaft.

In an embodiment, an output shaft of the linear driving motor is connected to the first linkage member and the second linkage member. The first linkage member is connected to the output shaft via a decouplable linkage mechanism, and the second linkage member is connected to the output shaft via a decouplable linkage mechanism.

In an embodiment, the focus ring replacement device further includes a limiting ring and an elastic member, and the limiting ring is fixed on the first linkage member. A spacing is present between the second linkage member and the limiting ring in the axial direction, and the limiting ring is configured to limit position of the second linkage member in the axial direction. The elastic member is arranged between the driving device and the second linkage member.

In an embodiment, the focus ring replacement device further includes a limiting ring and an elastic member, and the limiting ring is arranged between the driving device and the second linkage member. A spacing is present between the second linkage member and the limiting ring in the axial direction, and the limiting ring is configured to limit position of the second linkage member in the axial direction. The elastic member is arranged between the first linkage member and the second linkage member.

A plasma etcher is further provided according to the present application, which includes a vacuum reaction chamber, and the focus ring replacement device described above is arranged in the vacuum reaction chamber.

For a focus ring of an existing plasma etcher, a focus ring replacement device is provided according to the present application as a novel approach. An pin lifting mechanism of the focus ring replacement device includes a first pin and a first linkage member. The first pin is arranged at a top of the first linkage member and can extend out of a through-hole of an edge ring to raise a wafer. A focus ring lifting mechanism of the focus ring replacement device includes a second pin and a second linkage member. The second pin is arranged at a top of the second linkage member and can extend out of a through-hole of a base to raise a focus ring. A driving device of the focus ring replacement device is fixed below a lower electrode, and an output end of the driving device is connected to the first linkage member and the second linkage member to lift and lower the first pin of the pin lifting mechanism and the second pin of the focus ring lifting mechanism. In this way, the pin lifting mechanism and the focus ring lifting mechanism are driven by a single driving mechanism, which drives the pin for the wafer and the pin for the focus ring to move upward and downward. The structure is simple and reliable, and the configuration cost is effectively reduced. Moreover, the lifting and replacement processes of the focus ring will not affect the actual state of the pin lifting mechanism.

### BRIEF DESCRIPTION OF THE DRAWINGS

FIG. 1 is a schematic view showing the overall structure of a focus ring replacement device according to an embodiment of the present application;
FIG. 2 is a schematic view of the focus ring replacement device shown in FIG. 1 in an operation state;
FIG. 3 is a schematic view of the focus ring replacement device shown in FIG. 1 in another operation state;
FIG. 4 is a schematic view showing the overall structure of another focus ring replacement device according to an embodiment of the present application;
FIG. 5 is a schematic view showing a cooperation process of a limiting ring and an elastic member shown in FIG. 4;
FIG. 6 is a schematic view showing the overall structure of yet another focus ring replacement device according to an embodiment of the present application; and
FIG. 7 is a schematic view showing the overall structure of still another focus ring replacement device according to an embodiment of the present application.

Reference numerals:

| | | | |
|---|---|---|---|
| 10. | pin lifting mechanism; | 10b. | pin lifting mechanism; |
| 11. | first pin; | 11b. | first pin; |
| 12. | first linkage member; | 12b. | first linkage member; |
| 20. | focus ring lifting mechanism; | 20b. | focus ring lifting mechanism; |
| 21. | second pin; | 21b. | second pin; |
| 22. | second linkage member; | 22b. | second linkage member; |
| 30. | driving device; | 31. | outer output member; |
| 32. | inner output member; | 30a. | driving device; |
| 31a. | output shaft; | 30b. | driving device; |
| 31b. | first cylinder rod; | 32b. | second cylinder rod; |
| 30c. | driving device; | 311 c. | first output shaft; |
| 312c. | second output shaft; | 40. | base; |
| 50. | edge ring; | 60. | focus ring; |
| 70. | lower electrode; | 81. | limiting ring; |
| 82. | elastic member; | 83. | guide post; |
| 90. | lower electrode support seat. | | |

### DETAILED DESCRIPTION OF THE EMBODIMENTS

In order to enable those skilled in the art to better understand the technical solutions in the present application, the present application will be further described in detail below with reference to the accompanying drawings and specific embodiments.

According to a typical existing approach for the replacement of a focus ring that has been etched, a focus ring lifting structure is provided in a vacuum reaction chamber. The focus ring lifting structure includes a driving rod and a driving source for lifting and lowering the driving rod. A shielding ring is arranged below a base, and the driving source is arranged inside the shielding ring. The driving rod extends through the base to be located under the focus ring to move the focus ring upward and downward. The focus ring is lifted and lowered through the driving rod and the driving source for driving the upward and downward movements of the driving rod. The focus ring lifting structure employs a standalone driving device for lifting and lowering, which is independent of other lifting devices of the apparatus in practice, leading to a complex structure.

Based on this, a focus ring replacement device for a plasma etcher is provided according to an embodiment of the present application, so as to simplify the structure and reasonably control the manufacturing cost of the device. The focus ring displacement device is located in a vacuum reaction chamber and includes a driving device, an pin lifting mechanism and a focus ring lifting mechanism. The pin lifting mechanism and the focus ring lifting mechanism are driven by a single driving mechanism, which can drive a wafer pin of the pin lifting mechanism and a focus ring pin of the focus ring lifting mechanism to move upward and downward. The structure is simple and reliable, and the configuration cost is effectively reduced. Moreover, the lifting and replacement processes of the focus ring will not affect the actual state of the pin lifting mechanism.

Without loss of generality, this embodiment is described based on a focus ring, an edge ring, a lower electrode and other components having relative position relationships shown in the drawings, and the specific implementation and mechanism of the focus ring replacement device are described in detail. It should be understood that the specific implementations of the functions of the focus ring, the edge ring and the lower electrode do not lie in the core conception of the present application, and are not limited to the composition or structure shown in the drawings.

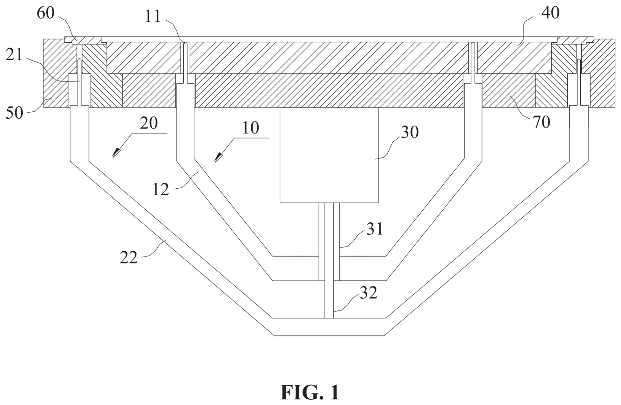

Please refer to FIG. 1, which is a schematic view showing the overall structure of a focus ring replacement device according to an embodiment of the present application.

As shown in FIG. 1, the focus ring replacement device includes an pin lifting mechanism 10, a focus ring lifting mechanism 20 and a driving device 30.

The pin lifting mechanism 10 includes a first pin 11 and a first linkage member 12, and the first pin 11 is arranged at a top of the first linkage member 12. When driven by the first linkage member 12, the first pin 11 can extend out of or retract into a through-hole of a base 40, so as to lift or lower a wafer. In this embodiment, multiple first pins 11 may be provided according to the actual application scenarios to meet different wafer production process requirements.

The focus ring lifting mechanism 20 includes a second pin 21 and a second linkage member 22, and the second pin 21 is arranged at a top of the second linkage member 22. When driven by the second linkage member 22, the second pin 21 can extend out of or retract into a through-hole of an edge ring 50, so as to lift or lower a focus ring 60 that is arranged on the edge ring 50. Similarly, multiple second pins 21 may be provided according to the overall design requirements of the device.

It is understandable that the multiple first pins 11 may be uniformly distributed in a circumferential direction, and the multiple second pins 21 may also be uniformly distributed in the circumferential direction to avoid unnecessary unbalanced load when performing the lifting and lowering operations. In a specific implementation, each of the first pin 11 and the second pin 21 includes a spherical protruding end, and each of the first pin 11 and the second pin 21 is made of a material including but not limited to ceramic, stainless steel, and the like.

The driving device 30 is fixed below a lower electrode 70, and an output end of the driving device 30 can provide a driving force to drive the upward and downward movements of the pin lifting mechanism 10 and the focus ring lifting mechanism 20. In this embodiment, the driving device 30 is a double-acting cylinder, which includes two output members, namely an outer output member 31 and an inner output member 32 that is inserted in the outer output member 31. The outer output member 31 and the inner output member 32 provide driving strokes with different linear displacements to respectively drive the first pin 11 and the second pin 21 to ascend and descend. In other words, the outer output member 31 has a first driving stroke, and the inner output member 32 has a second driving stroke. After the outer output member 31 completes the first driving stroke, the inner output member continues to output until the second driving stroke is completed. The lifting and replacement processes of the focus ring will not affect the upward and downward movements of the first pin.

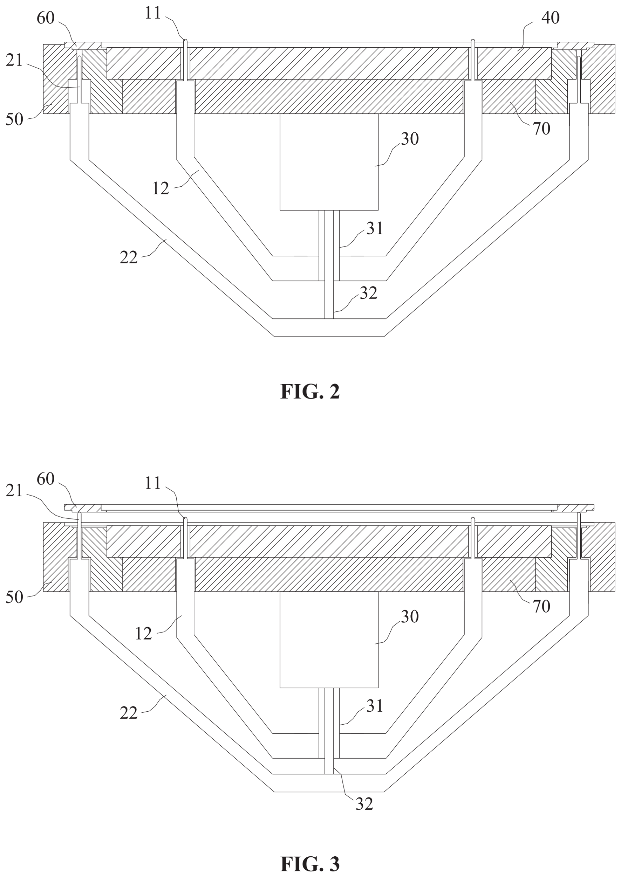

Specifically, the outer output member 31 of the double-acting cylinder is connected to the first linkage member 12, and the outer output member meets the stroke requirement of the first pin 11. Please refer to FIG. 2, FIG. 2 is a schematic view of the first pin of the focus ring replacement device shown in FIG. 1 in a lifted state. Correspondingly, the inner output member 32 of the double-acting cylinder is connected to the second linkage member 22, and the outer output member meets the stroke requirement of the second pin 21. Please refer to FIG. 3, which is a schematic view of the second pin of the focus ring replacement device shown in FIG. 1 in a lifted state. It should be noted that the specific functions of the double-acting cylinder do not lie in the core conception of the present application, and can be implemented by those skilled in the art based on the conventional technology, so its details will not be described herein.

Certainly, in this embodiment, the double-acting cylinder is configured in the following manner: a difference between the first driving stroke and the second driving stroke is greater than or equal to a thickness of the focus ring 60, so as to facilitate a manipulator to replace the focus ring 60 when the second pin 21 is raised.

Based on the driving function requirements of the inner output member 32 and the outer output member 31 of the double-acting cylinder, a junction between the second linkage member 22 and the inner output member 32 is located below a junction between the first linkage member 12 and the outer output member 31.

In a specific implementation, the first linkage member 22 and the second linkage member 22 may have different structures rather than being limited to the structures shown in the drawings. It is understandable that, these structures fall within the protection scope of the present application as long as they meet the functional requirements for assembling the pins and driving the corresponding pins to ascend and descend.

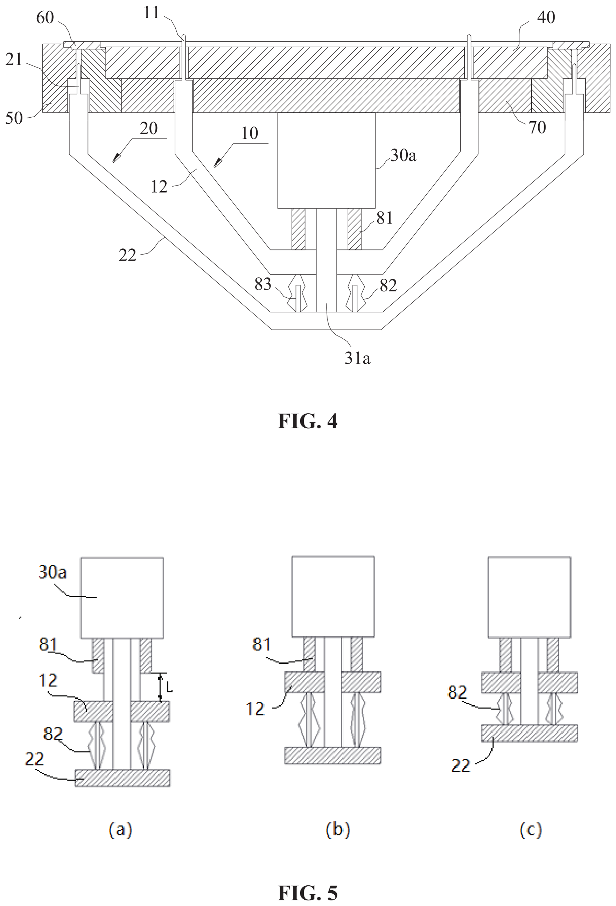

In addition to the above double-acting cylinder, the driving device for providing the driving force may alternatively be a linear motor. Please refer to FIG. 4, which is a schematic view showing the overall structure of another focus ring replacement device according to an embodiment of the present application. In order to clearly illustrate the differences and relationship between this embodiment and the embodiment described in FIG. 1, the components or structures having the same functions are indicated by the same reference numerals in the drawings.

In this embodiment, a linear motor serves as the driving device 30a, and an output shaft 31a of the linear motor can drive the first linkage member 12 and the second linkage member 22 to move. Similarly, a junction between the second linkage member 22 and the output shaft 31a is located below a junction between the first linkage member 12 and the output shaft 31a.

The second linkage member 22 is fixedly connected to the output shaft 31a, and the first linkage member 12 is connected to the output shaft 31a via a linkage mechanism (not shown in the drawings). The linkage mechanism is configured to be decoupled from the output shaft 31a when an axial relative force between the first linkage member 12 and the output shaft 31a is greater than a preset coupling threshold. That is to say, the linkage mechanism is decoupled when a force that moves the output shaft 31a upward in the axial direction with respect to the second linkage member 22 is relatively large.

The orientation term "axial" herein is defined based on a central component of the plasma reaction chamber. It should be understood that the corresponding orientation term is only used to clearly describe the shape or relative position relationship of the corresponding component or structure, and does not constitute a substantial limitation to the technical solution claimed in the present application.

In a specific implementation, the linkage mechanism may be implemented in different structural forms, which will not be described in detail herein.

A limiting ring 81 is provided on the driving device 30a, and there is a spacing L between the first linkage member 12 and the limiting ring 81 in the axial direction. Correspondingly, an elastic member 82 is provided between the first linkage member 12 and the second linkage member 22, and the elastic deformation of the elastic member 82 can meet the stroke requirements. Please refer to FIG. 5, which is a schematic view showing a cooperation process of the limiting ring 81 and the elastic member 82 shown in FIG. 4.

In an initial state shown in (a) of FIG. 5, there is a spacing L between the first linkage member 12 and the limiting ring 81, and each of the first pin 11 and the second pin 21 is in a lowered state. As shown in (b) of FIG. 5, the output shaft 31a of the driving device 30a moves upward until the first linkage member 12 abuts against the limiting ring 81. At this time, the first pin 11 is in a lifted state, and the second pin 21 is in the lowered state. As shown in (c) of FIG. 5, the first linkage member 12 abuts against the limiting ring 81 and remains stationary, and the output shaft 31a of the driving device 30a continues to move upward. The linkage mechanism between the first linkage member 12 and the limiting ring 81 is decoupled, and the output shaft 31a drives the second linkage member 22 to continue to move upward. Meanwhile, the elastic member 82 is compressed and deformed, so that the first linkage member 12 can stably move upward. The lifting and replacement processes of the focus ring will not affect the upward and downward movements of the first pin.

In a specific implementation, the elastic member 82 may be a spring, a bellows or a rubber member. In the cases that the elastic member 82 is a spiral spring or a bellows, a guide post 83 may be further provided, and the elastic member 82 is arranged around the guide post 83, so as to avoid lateral deviation of the elastic member 82 during compression.

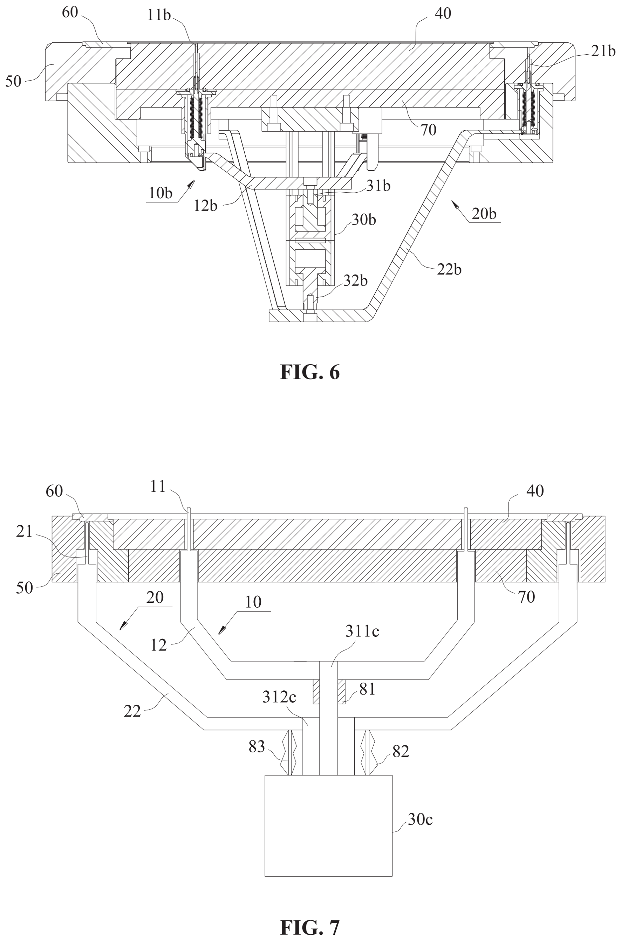

In addition, the driving device for providing the driving force may alternatively be a double-ended cylinder. Please refer to FIG. 6, which is a schematic view showing the overall structure of yet another focus ring replacement device according to an embodiment of the present application. In order to clearly illustrate the differences and relationships between this embodiment and the embodiments described in FIG. 1 and FIG. 4, the components or structures with the same functions are indicated by the same reference numerals in the drawings.

In this embodiment, the driving device 30b is a double-ended cylinder, which includes two cylinder rods that extend in opposite directions. A first cylinder rod 31b of the driving device 30b is connected to the first linkage member 12b of the pin lifting mechanism 10b, and can drive the first linkage member 12b to move upward and downward. A second cylinder rod 32b of the driving device 30b is connected to the second linkage member 22b of the focus ring lifting mechanism 20b, and can drive the second linkage member 22b to move upward and downward.

The first pin 11b of the pin lifting mechanism 10b extends out of a through-hole of the base 40, and the first pin 11b and the base 40 are sealed by a sealing ring. The second pin 21b of the focus ring lifting mechanism 20b is partially located in a mounting groove of a lower electrode support seat 90, and the second pin 21b and the edge ring 50 are sealed by a sealing ring to ensure the sealing of the vacuum chamber. The lifting and replacement processes of the focus ring will not affect the upward and downward movements of the first pin.

In this embodiment, the driving forces are provided by the double-ended cylinder to lift and lower the first pin 11b and the second pin 21b. That is, the first pin 11b and the second pin 21b are controlled by a single cylinder but do not interfere with each other. In this embodiment, the structure is simple and easy to implement.

In the foregoing embodiments, the driving device of the focus ring replacement device is fixed under the lower electrode, that is, located above the junctions between the corresponding linkage members and the output ends of the driving device. In other specific implementations, the driving device is located below the junctions between the corresponding linkage members and the output ends of the driving device. Please refer to FIG. 7, which is a schematic view showing the overall structure of still another focus ring replacement device according to an embodiment of the present application. In order to clearly illustrate the differences and relationship between this embodiment and the embodiment described in FIG. 4, the components or structures with the same functions are indicated by the same reference numerals in the drawings.

In this embodiment, the driving device 30c is located below the first linkage member 12 and the second linkage member 22, and is fixed. Specifically, the driving device 30c may be fixed on an inner wall of the vacuum reaction chamber (not shown in the drawings).

The driving device 30c is a linear motor, which can drive the first linkage member 12 and the second linkage member 22 to move. The driving device 30c is located below the first linkage member 12 and the second linkage member 22, and similarly, a junction between the second linkage member 22 and an output shaft 31c is located below a junction between the first linkage member 12 and the output shaft 31c.

Specifically, the driving device 30c is connected to the first linkage member 12 via a first output shaft 311c, and connected to the second linkage member 22 via a second output shaft 312c, so as to respectively control the first pin 11 and the second pin 21 to move upward and downward through the output strokes of the two output shafts.

In other specific implementations, alternatively, the first linkage member 12 and the second linkage member 22 are lifted and lowered through a single output shaft. Specifically, the first linkage member 12 and the second linkage member 22 may be respectively connected to the output shaft via linkage mechanisms (not shown in the drawings), and coupling relationships may be established according to the functional requirements in actual operations. Accordingly, the linkage mechanisms may be implemented in different structural forms, which will not be described in detail herein.

In this embodiment, the limiting ring 81 is fixed below the first linkage member 12 and is located between the first linkage member 12 and the second linkage member 22. Furthermore, there is a spacing between the second linkage member 22 and the limiting ring 81, and the limiting ring 81 is configured to limit a stroke of the second linkage member 22. Herein, the elastic member 82 is arranged between the driving device 30c and the second linkage member 22 to provide a necessary buffering effect during the downward movement of the second linkage member 22.

Certainly, in other specific implementations, the limiting ring may be arranged between the driving device 30c and the second linkage member 22 (not shown in the drawings) to limit the downward movement of the second linkage member 22. Correspondingly, the elastic member is arranged between the first linkage member 12 and the second linkage member 22 to provide a buffering effect when there is a relative displacement between the first linkage member 12 and the second linkage member 22.

In addition to the above focus ring replacement device, a plasma etcher is further provided in this embodiment. The plasma etcher includes a vacuum reaction chamber and the above focus ring replacement device, so as to realize the replacement of a focus ring of the plasma etcher.

It should be understood that other functions of the plasma etcher do not lie in the core conception of the present application, and can be implemented by those skilled in the art based on the conventional technology, so their details will not be described herein.

The above embodiments are only preferred embodiments of the present application. It should be noted that, for those skilled in the art, several improvements and modifications may be made without departing from the principle of the present application, and these improvements and modifications also fall within the protection scope of the present application.

## Claims

1. A focus ring replacement device for a plasma etcher, comprising:
a driving device (30, 30a, 30b, 30c);
an pin lifting mechanism (10, 10b); and
a focus ring lifting mechanism (20, 20b), wherein
the pin lifting mechanism (10, 10b) comprises a first pin (11, 11b) and a first linkage member (12, 12b), and the first pin (11, 11b) is arranged at a top of the first linkage member (12, 12b) and is configured to extend out of a through-hole of an edge ring (50);
the focus ring lifting mechanism (20, 20b) comprises a second pin (21, 21b) and a second linkage member (22, 22b), and the second pin (21, 21b) is arranged at a top of the second linkage member (22, 22b) and is configured to extend out of a through-hole of a base (40); and
the driving device (30, 30a, 30b, 30c) is fixed below a lower electrode (70), and an output end of the driving device (30, 30a, 30b, 30c) is connected to the first linkage member (12, 12b) and the second linkage member (22, 22b), and is configured to lift and lower the first pin (11, 11b) of the pin lifting mechanism (10, 10b) and the second pin (21, 21b) of the focus ring lifting mechanism (20, 20b).

2. The focus ring replacement device according to claim 1, wherein the number of the first pin (11, 11b) and the number of the second pin (21, 21b) are both plural, the plurality of first pins (11, 11b) are uniformly distributed in a circumferential direction, and the plurality of second pins (21, 21b) are uniformly distributed in the circumferential direction.

3. The focus ring replacement device according to claim 1, wherein each of the first pin (11, 11b) and the second pin (21, 21b) comprises a spherical protruding end.

4. The focus ring replacement device according to claim 1, wherein each of the first pin (11, 11b) and the second pin (21, 21b) is made of ceramic or stainless steel.

5. The focus ring replacement device according to any one of claims 1 to 4, wherein
the driving device (30) is a double-acting cylinder, which comprises an outer output member (31) and an inner output member (32) that is inserted in the outer output member (31), and a lower end of the inner output member (32) extends out of the outer output member (31); and
the outer output member (31) is connected to the first linkage member (12), and the inner output member (32) is connected to the second linkage member (22).

6. The focus ring replacement device according to claim 5, wherein the outer output member (31) has a first driving stroke, the inner output member (32) has a second driving stroke, the driving second stroke is greater than the first driving stroke, and a difference between the second driving stroke and the first driving stroke is greater than or equal to a thickness of a focus ring (60).

7. The focus ring replacement device according to any one of claims 1 to 4, wherein
the driving device (30a) is a linear driving motor, an output shaft (31a) of the linear driving motor is connected to the first linkage member (12) via a decouplable linkage mechanism, and the output shaft (31a) is fixedly connected to the second linkage member (22); and
a junction between the second linkage member (22) and the output shaft (31a) is located below a junction between the first linkage member (12) and the output shaft (31a).

8. The focus ring replacement device according to claim 7, wherein the linkage mechanism is configured to be decoupled when an axial force between the first linkage member (12) and the output shaft (31a) is greater than a coupling threshold.

9. The focus ring replacement device according to claim 8, wherein a limiting ring (81) is provided on the driving device (30a) and is arranged around the output shaft (31a), a spacing is present between the first linkage member (12) and the limiting ring (81) in an axial direction, and the limiting ring (81) is configured to limit position of the first linkage member (12) in the axial direction to facilitate the decoupling of the linkage mechanism.

10. The focus ring replacement device according to claim 9, further comprising an elastic member (82), which is provided between the first linkage member (12) and the second linkage member (22), and is configured to be deformed when the second linkage member (22) drives the second pin (21) to raise a focus ring (60).

11. The focus ring replacement device according to claim 10, further comprising a guide post (83), wherein the elastic member (82) is arranged around the guide post (83).

12. The focus ring replacement device according to claim 10, wherein the elastic member (82) is a spring, a bellows, or a rubber member.

13. The focus ring replacement device according to any one of claims 1 to 4, wherein
the driving device (30b) is a double-ended cylinder, which comprises a first cylinder rod (31b) and a second cylinder rod (32b) that extend in opposite directions; and
the first cylinder rod (31b) is connected to the first linkage member (12b) of the pin lifting mechanism (10b), and the second cylinder rod (32b) is connected to the second linkage member (22b) of the focus ring lifting mechanism (20b).

14. The focus ring replacement device according to claim 13, wherein the second pin (21b) of the focus ring lifting mechanism (20b) is partially located in a mounting groove of a lower electrode support seat (90).

15. The focus ring replacement device according to claim 13, wherein a seal is provided between the first pin (11b) and the base (40), and a seal is provided between the second pin (21b) and the edge ring (50).

16. The focus ring replacement device according to claim 1, wherein the driving device (30c) is fixed below the first linkage member (12) and the second linkage member (22).

17. The focus ring replacement device according to claim 16, wherein the driving device (30c) is a linear driving motor, a first output shaft (311c) of the linear driving motor is connected to the first linkage member (12), a second output shaft (312c) of the linear driving motor is connected to the second linkage member (22), and a junction between the second linkage member (22) and the second output shaft (312c) is located below a junction between the first linkage member (12) and the first output shaft (311c).

18. The focus ring replacement device according to claim 17, wherein an output shaft of the linear drive motor is connected to the first linkage member (12) and the second linkage member (22), the first linkage member (12) is connected to the output shaft via a decouplable linkage mechanism, and the second linkage member (22) is connected to the output shaft via a decouplable linkage mechanism.

19. The focus ring replacement device according to claim 17 or 18, further comprising a limiting ring (81) and an elastic member (82), wherein the limiting ring (81) is fixed on the first linkage member (12), and a spacing is present between the second linkage member (22) and the limiting ring (81) in the axial direction, the limiting ring (81) is configured to limit position of the second linkage member (22) in the axial direction, and the elastic member (82) is arranged between the driving device (30c) and the second linkage member (12).

20. The focus ring replacement device according to claim 17 or 18, further comprising a limiting ring and an elastic member, wherein the limiting ring is arranged between the driving device (30c) and the second linkage member (22), a spacing is present between the second linkage member (22) and the limiting ring in an axial direction, the limiting ring (81) is configured to limit position of the second linkage member (22) in the axial direction, and the elastic member is arranged between the first linkage member (12) and the second linkage member (22).

21. A plasma etcher, comprising a vacuum reaction chamber, wherein the focus ring replacement device according to any one of claims 1 to 20 is arranged in the vacuum reaction chamber.
